(19) **Europäisches Patentamt**

**European Patent Office**

**Office européen des brevets**

(11) **EP 1 384 396 B1**

(12) **EUROPEAN PATENT SPECIFICATION**

(45) Date of publication and mention
of the grant of the patent:
**05.07.2006 Bulletin 2006/27**

(51) Int Cl.:
***H05K 1/02*** (2006.01)

(21) Application number: **02766904.3**

(22) Date of filing: **30.04.2002**

(86) International application number:
**PCT/US2002/014061**

(87) International publication number:
**WO 2002/089539 (07.11.2002 Gazette 2002/45)**

(54) **INTEGRATED COOLING OF A PRINTED CIRCUIT BOARD STRUCTURE**

INTEGRIERTE KÜHLUNG EINER LEITERPLATTENSTRUKTUR

REFROIDISSEMENT INTEGRE D'UNE STRUCTURE DE CARTE A CIRCUIT INTEGRE

(84) Designated Contracting States:
**AT BE CH CY DE DK ES FI FR GB GR IE IT LI LU MC NL PT SE TR**

(30) Priority: **01.05.2001 US 847746**

(43) Date of publication of application:
**28.01.2004 Bulletin 2004/05**

(73) Proprietor: **Infineon Technologies AG**
**81669 München (DE)**

(72) Inventors:
• **BARTOLA, Robert**
  **Pottstown, PA 19465 (US)**
• **MOGEL, James**
  **Boyertown, PA 19512 (US)**
• **LAUREANTI, Steven, J.**
  **Lewisville, TX 75067 (US)**

(74) Representative: **Schweiger, Martin**
  **Karlstrasse 35**
  **80333 München (DE)**

(56) References cited:
**US-A- 4 019 098          US-A- 5 142 441**
**US-A- 5 659 458**

**Description**

FIELD OF THE INVENTION

This invention pertains generally to thermal management of electronic devices and, more particularly, to cooling of electronic power transistor devices and printed circuit boards.

BACKGROUND

Electronic components typically generate some heat as electrical energy is partially converted to thermal energy due the losses in the respective components. It is normally desirable to remove the heat from these components in a rapid and efficient manner, since increased temperature can effect performance, shorten the lifetime, and cause premature failure of many types of electronic components. Power transistors, such as laterally diffused metal oxide silicon (LDMOS) field effect transistors (FETs) commonly used in RF power amplifiers, are especially susceptible to overheating. These devices typically handle the large part of the power flowing through the amplifier and consequently need to dissipate the most thermal energy. This tends to make them operate at higher temperatures than other amplifier components. In addition, amplifier efficiency tends to drop as the power transistors heat up, producing still more heat to dissipate and higher temperatures. Further, while semiconductor processing and packaging improvements have allowed designers to produce smaller electronic devices which operate at higher power, the associated increased operating temperatures have limited maximum safe power levels.

One traditional method of cooling electronic power devices involves dispersing the heat generated by the device through its support structure, e.g. a metallic flange, and into a heat sink, typically a ceramic or metal material, which, in turn, dissipates the thermal energy to the environment. Of course, the device temperature depends on thermal resistance of all of the materials carrying heat away from the active components of the device, typically one or more semiconductor chips.

Thermal resistance, R, is defined by the temperature drop between its endpoints and the heat flow through it:

$$T1 - T2 = R * Q \quad (1)$$

where T1 and T2 are the temperatures at the endpoints, and Q is the rate of heat flow. Thermal resistance for one dimensional heat flow in a uniform material is proportional to the length of the conducting material, and inversely proportional to the conduction area and thermal conductivity of the material, or:

$$R = L / (A * alpha) \quad (2)$$

where alpha is the thermal conductivity, A is the cross sectional area, and L is the length of the conducting material.

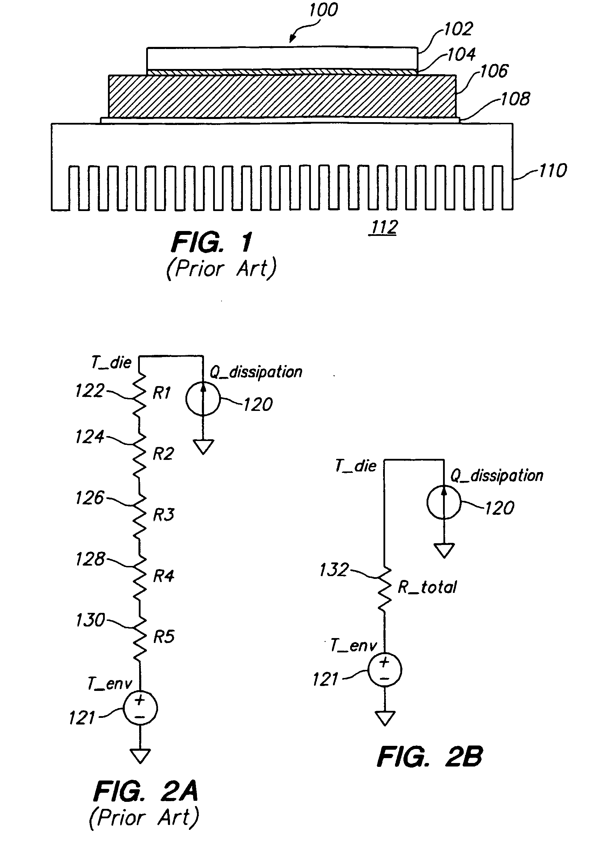

FIG. 1 illustrates an exemplary electronic device 100, including a transistor die 102, die-to-flange conductive layer 104, mounting flange 106, thermal grease or solder bond layer 108 and heat sink 110. Heat produced by electrical conduction through the die 102 is transferred by passing through the die 102, conductive layer 104, flange 106, thermal grease or solder bond 108, and heat sink 110, respectively, finally dissipating into the environment 112. As the heat flows, the temperature of each element in the thermal path is successively lower, i.e. the temperature of die 102 is the highest, the temperature in the conductive layer 104 is less than the die 102, and so on. The temperature of the environment 112 is the lowest.

FIG. 2A is a thermal model for the system shown in FIG. 1. The power dissipated by die 102 is represented by heat source 120. As this heat flows through thermal resistors 122, 124, 126, 128 and 130, there is a temperature drop across each.

There are numerous ways to estimate the values for thermal resistances. First, second and third thermal resistances122, 123, 124 can be estimated using equation (2). Heat sinks, such as heat sink 110, are commercially available in many forms and well known in the art. The thermal resistances of a heat sink are usually specified by the manufacturer or can be determined from performance curves.

Since the intermediate temperatures associated with the conductive layer, flange, thermal grease or solder bond, and heat sink are rarely important to this type of thermal analysis, the thermal model can be greatly simplified as shown in FIG. 2B. Total thermal resistance 132 is the algebraic sum of the first through fifth thermal resistances shown in FIG. 2A.

The temperature of the die 122 is easily calculated from this model:

$$T\_die = T\_env + (Q\_dissipation * R\_total) \quad (3)$$

The power dissipated by die 102 is usually specified, based on the application. The temperature of the environment is typically not controlled, and for devices located outdoors (e.g., in a wireless network base station), can vary widely with season, time of day, and geography. Of course, the object is to keep the temperature of the die 102 as close as possible to the temperature of the environment 112. Towards this end, the most effective way to reduce the temperature difference is to reduce the total thermal resistance 132.

SUMMARY OF THE INVENTION

In accordance with one aspect of the invention, a more efficient thermal management system for cooling of electronic components, such as power transistors, is achieved by providing close thermal contact of a bulk coolant flowing through channels formed inside or on the surface of a printed circuit board (PCB) carrying electronic components.
In one embodiment, flow channels are formed in the layers of a multilayer PCB in close proximity to selected electronic components, such that heat produced by the electronic components is efficiently carried by bulk motion of the coolant to a heat sink, where the heat is then delivered to the environment. In particular, as the coolant passes under the heat producing components, thermal energy is transferred from the components and into the coolant. The circulation of the coolant serves to rapidly transfer thermal energy away from the heat producing components and delivers the heat to the heat sink, which facilitates the transfer of thermal energy from the coolant to the environment.
Other aspects, objects and features of the present invention will become apparent hereinafter.

BRIEF DESCRIPTION OF THE DRAWINGS

The drawings illustrate both the design and utility of the preferred embodiments of the present invention, in which similar elements in different embodiments are referred to by the same reference numbers for ease in illustration, and in which:

FIG. 1 is a cross-sectional diagram illustrating prior art cooling of an electronic device.
FIG. 2A is a detailed thermal model for the heat flow to the environment of the device of FIG. 1.
FIG 2B is a more simplified thermal model for the heat flow to the environment of the device of FIG. 1.
FIG. 3 is a cross-sectional diagram of an electronic device attached to a multilayer PCB, with a preferred thermal management system provided for cooling the electronic device, the thermal management system having a cooling channel formed in the PCB.
FIG. 4 is a cross-sectional diagram of the electronic device of FIG. 3 attached to a multilayer PCB, with an alternate preferred thermal management system provided for cooling the electronic device, the thermal management system having a cooling channel formed between a layer of the PCB and a mounting flange of the electronic device.
FIG. 5 is a cross section of a portion of a cooling channel in the PCB of FIG. 4.
FIG. 6 is a cross-sectional diagram of a plurality of electronics devices attached to a multilayer PCB and cooled by a still further preferred thermal management system, including a cooling channel formed between layers of the PCB and respective mounting flanges of the electronic devices.
FIG. 7 is a cross-sectional diagram of yet a further preferred thermal management system integrated in a PCB for cooling an attached electronic device.

DETAILED DESCRIPTION OF THE PRFERRED EMBODIMENTS

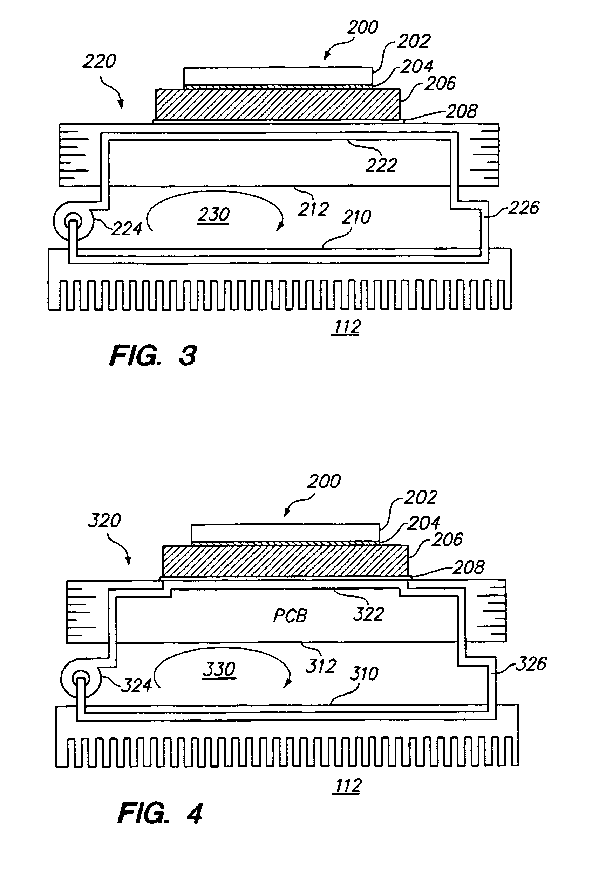

Referring to FIG. 3, in accordance with a first aspect of the invention, an electronic device 200, includes a transistor die 202 attached to a mounting flange 206 via a conductive layer 204. The mounting flange 206 is attached to a multilayer printed circuit board (PCB) 212 by a thermal grease or solder bond 208. The device 200 is cooled by a thermal management system 220, which employs a coolant 226 circulating through a closed cooling loop 230. The cooling loop 230 comprises a flow channel 222 and a circulation pump 224. Coolant 226 is pumped around the cooling loop 230 and passes through the heated portion of flow channel 222, the cooled portion of flow channel 222 and the circulation pump 224. Heat is transferred by bulk motion of the coolant 226 from the heated portion of flow channel 222 to the cooled portion of flow channel 222. The coolant 226 may be a gas or a liquid, and preferably has a relatively low thermal resistance.

In particular, heat flows from the transistor die 202 and to the coolant 226 as the coolant 226 passes through the flow channel 222. Heat flows from the coolant 226 and into the environment 112 as the coolant 226 passes through the cooled portion of the flow channel 222, which is thermally coupled to the heat sink 210. Heat sink 210 facilitates the flow of heat from the coolant 226 into the environment 112.

The heated portion of flow channel 222 is fully contained by the PCB 212 and formed in close proximity to the flange 206 in order to minimize the thermal resistance between the flange 206 and the heated portion of the flow channel 222. This, in turn, minimizes the temperature drop from the flange 206 to the coolant 226 as it passes through the heated portion of the flow channel 222, which maximizes the heat flow from the transistor die 202 into the coolant 226.

Carrying heat by bulk motion of the coolant 226 from the heated portion to the cooled portion of the flow channel 222 tends to minimize the temperature difference between the PCB 212 in the vicinity of device 200 and the heat sink 210. This, in turn, tends to minimize the temperature difference between transistor die 202 and the environment 112, thus lowering the temperature of the die 202.

In accordance with a further aspect of the invention, and referring to the electronic device 200, it may be advantageous in some applications to eliminate the mounting flange 206 and attach the transistor die 202 directly to the PCB 212 by other means. For example, the transistor die 202 may be attached directly to an integral conductive (e.g., gold or copper) foil layer on the surface of the PCB 212. In this case, the die 202 is preferably attached to the foil via a die-to-foil conductive layer, which provides good electrical conductivity as well as good thermal conductivity. The thermal resistance associated with the flange 206 and die-to-flange conductive layer 208 are thus eliminated and replaced by (much lower) thermal resistances associated with the foil layer and the die-to-foil conductive layer. A practitioner, skilled in the art, will appreciate that heat produced by the transistor die 202 can be transferred to the coolant 226 more efficiently in some applications using this alternative means for attaching the die 202 to the PCB 212.

Referring to FIG. 4, in accordance with a further aspect of the invention, the electronic device 200 is cooled by an alternate thermal management system 320, which includes a coolant 326 circulating through a closed cooling loop 330. System 320 is similar to system 220 of FIG. 3, but includes direct contact of the coolant 326 with the device 200, which is attached to a multilayer PCB 312.

The cooling loop 330 comprises a flow channel 322 and a circulation pump 324. Coolant 326 is pumped through the cooling loop 330, passing through the heated portion of flow channel 322, the cooled portion of flow channel 322, and the circulation pump 324, respectively. Heat is transferred by bulk motion of the coolant 326 from the heated portion of flow channel 322 to the cooled portion of flow channel 322.

In particular, heat flows from the transistor die 202 to the coolant 326 as the coolant 326 passes through the flow channel 322. Heat flows from the coolant 326 and into the environment 112 as the coolant 326 passes through the cooled portion of the flow channel 322, which is thermally coupled to a heat sink 310. Heat sink 310 facilitates the flow of heat from the coolant 326 into the environment 112.

The heated portion of flow channel 322 is partially contained by the PCB 312 and partially contained by the mounting flange 206. As coolant passes through the heated portion of flow channel 322 in the vicinity of the mounting flange 206, there is direct contact of the coolant 326 with the mounting flange 206, in order to minimize the temperature drop between the flange 206 and the coolant 326. In order to prevent coolant leakage, the flange 206 is preferably sealed to the surface of the PCB 312. Numerous materials are acceptable sealants and include polymer sealants and solder, as in solder bond 208. The remaining portions of the heated flow channel 322 are fully contained within the PCB 312. As the coolant 326 passes through the cooled portion of the flow channel 322, which is thermally coupled to the heat sink 310, heat flows from the coolant 326, through the heat sink 310, and into the environment 112.

Having direct contact between the coolant 326 and the flange 206 eliminates the thermal resistance of the PCB 312, which lowers the temperature difference between the flange 206 and the coolant 326. This, in turn, lowers the temperature of the transistor die 202 even more efficiently that the thermal management system 220, although the efficiency advantage is somewhat offset by the increased complexity and extra cost associated with properly sealing the flange 206 to the PCB 312.

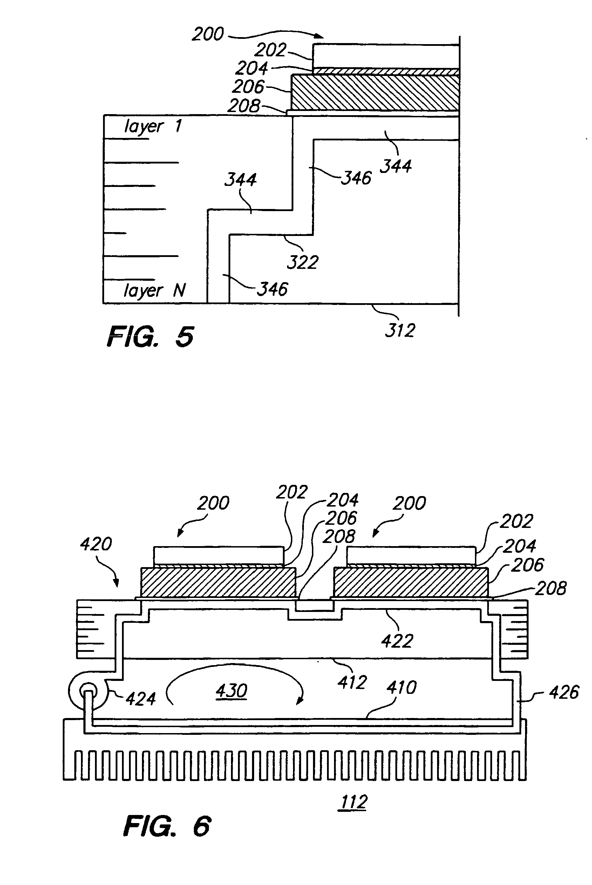

FIG. 5 is a detailed drawing of a portion of the flow channel 322 in the vicinity of device 200 which illustrates formation of the flow channel 322 among the layers 1-N of the PCB 312. In particular, the flow channel 322 formed in the PCB 312 is a series of interconnected segments which allow coolant 326 to flow. The portions of the flow channel 322 illustrated as horizontal segments 344 may be formed by removing a volume of bulk material from the corresponding PCB layer during the manufacturing or assembly process. The portions of the flow channel 322 illustrated as vertical segments 346 may be formed by coincident layer-to-layer vias. Interconnection of a horizontal segment 344 with a vertical segment 336 can be made by having the via on one PCB layer coincide with a horizontal segment 344 on an adjacent layer.

Referring to FIG. 6, in accordance with a still further aspect of the invention, multiple devices 200 are attached to a PCB 412 and cooled by a thermal management system 420, which employs a coolant 426 and a closed cooling loop 430. The cooling loop 430 comprises a flow channel 422 and a circulation pump 424. Coolant is pumped around the cooling loop 430 and is heated as it passes in the vicinity of devices 200. Heat is transferred by bulk motion of the coolant 426 from the vicinity of devices 200 to the cooled portion of the flow channel 422.

In particular, heat flows from the die 202 of each device 200 to the coolant 426 as the coolant 426 passes through the flow channel 422 in the vicinity of the respective die 202. Heat flows from the coolant 426, and into the environment 112, as the coolant 426 passes through a heat sink 410. The heat sink 410 facilitates the flow of heat from the coolant 426 into the environment 112. Although FIG. 6 shows a flow channel 422 which has direct contact of the coolant 226 with flanges 208, it is understood that close proximity (as illustrated in FIG. 3) is also within the scope of the invention.

Cooling a plurality of devices 200 with a single cooling loop has the advantage of lower cost than multiple independent cooling loops. This advantage is offset, to some degree, by the increased complexity of the cooling loop and somewhat decreased efficiency.

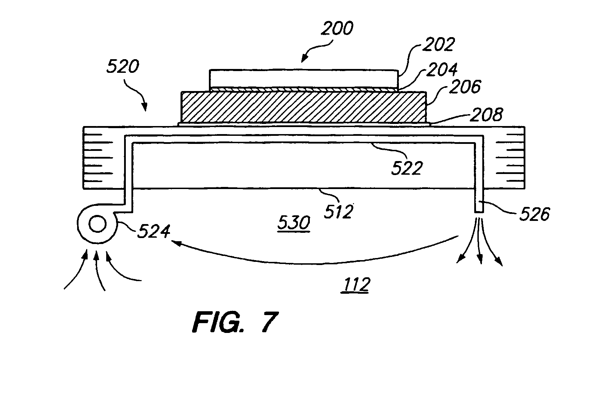

Referring to FIG. 7, in accordance with a further aspect of the invention, an electronic assembly 200, including a transistor die 202 attached to a mounting flange 206 via a conductive layer 204 is attached to a multilayer PCB 512 by a thermal grease or solder bond 208. The device 200 is cooled by a thermal management system 520, which employs a coolant 226 and an open cooling loop 530. The cooling loop 530 comprises a flow channel 522 and a circulation pump 524. Coolant 526 is drawn in from the surroundings by circulation pump 524 and pumped through the heated portion of flow channel 522 where the coolant is expelled into the surroundings. Heat is transferred by bulk motion of the coolant 526 from the heated portion of flow channel 522 to the surroundings and, in turn, to the environment 112.

In particular, heat flows from the transistor die 202 to the coolant 526 as the coolant 526 passes through the flow channel 522. Heat flows from the coolant 526 and into the environment 112 as the coolant 226 is expelled into the surroundings.

A practitioner, skilled in the art, will appreciate that the flow channel 522 depicted in FIG. 7 could alternately be implemented in a way similar to that depicted in FIG. 4, FIG. 5, or FIG. 6.

Accordingly, the invention is not to be restricted, except as set forth in the following claims.

**Claims**

1. A printed circuit board (PCB), comprising:

   a mounting area for attaching one or more heat producing devices;
   a coolant circulation channel at least partially formed in a layer of the PCB, the channel having a portion in a vicinity of the mounting area, wherein a portion of the channel is formed by coinciding vias located in adjacent layers of the PCB and wherein a portion of the channel is formed by a surface of a device attached to the mounting area.

2. The PCB of claim 1, wherein the PCB is a multilayer PCB, and wherein a portion of the channel is formed by removal of portions of one or more layers of the PCB.

3. The PCB of claim 1, wherein the channel carries a coolant.

4. The PCB of claim 3, wherein the coolant is a gas.

5. The PCB of claim 3, wherein the coolant is a liquid.

6. The PCB of claim 1, wherein the device comprises a transistor die attached to a mounting flange, the mounting flange attached to the mounting area and comprising the surface forming the respective portion of the channel.

7. The PCB of claim 1, wherein the device comprises a transistor die attached to the mounting area, the transistor die comprising the surface forming the respective portion of the channel.

8. The PCB of claim 1, comprising a plurality of device mounting areas for attaching heat producing devices, the channel having a portion in a vicinity of each mounting area.

**Patentansprüche**

1. Gedruckte Leiterplatte (PCB), die nachfolgendes umfasst:

einen Bestückungsbereich für das Verbinden mit einem oder mehreren Wärme erzeugenden Anordnungen; einen mindestens teilweise in einer Schicht des PCB ausgeformten Kühlmittelzirkulationskanal, mit einem Teil des Kanals in einer Umgebung des Montagebereichs, wobei ein Teil des Kanals ausgeformt wird durch zusammentreffende Durchgangslöcher, die sich in benachbarten Schichten des PCB befinden und wobei ein Teil des Kanals von einer Oberfläche einer im Bestückungsbereich angeschlossenen Anordnung ausgeformt wird.

2. PCB nach Anspruch 1, wobei das PCB ein Vielschicht-PCB ist und wobei ein Teil des Kanals ausgeformt wird durch Entfernen von Teilen von einer oder mehreren Schichten des PCB.

3. PCB nach Anspruch 1, wobei der Kanal ein Kühlmittel befördert.

4. PCB nach Anspruch 3, wobei das Kühlmittel ein Gas ist.

5. PCB nach Anspruch 3, wobei das Kühlmittel eine Flüssigkeit ist.

6. PCB nach Anspruch 1, wobei die Anordnung einen an einem Befestigungsflansch befestigten Transistorchip umfasst, der Befestigungsflansch mit dem Bestückungsbereich verbunden ist und die Oberfläche umfasst, die den zugehörigen Teil des Kanals ausformt.

7. PCB nach Anspruch 1, wobei die Anordnung einen mit dem Bestückungsbereich verbundenen Transistorchip umfasst, der Transistorchip die Oberfläche umfasst, die den zugehörigen Teil des Kanals ausformt.

8. PCB nach Anspruch 1, das eine Vielzahl von Bestückungsbereichen für Anordnungen für das Befestigen von Wärme erzeugenden Anordnungen umfasst, wobei der Kanal einen Teilbereich in dem umgebenden Bereich jedes Bestückungsbereichs aufweist.

## Revendications

1. Carte à circuit imprimé comprenant :

une surface de montage pour y attacher un ou plusieurs dispositifs producteurs de chaleur ;
un canal de circulation de fluide de refroidissement au moins partiellement formé dans une couche de la carte à circuit imprimé, ce canal ayant une portion à proximité de la surface de montage, une portion du canal étant formée par des trous d'interconnexion coïncidents situés dans des couches adjacentes de la carte à circuit imprimé et une portion du canal étant formée par une surface d'un dispositif attaché à la surface de montage.

2. La carte à circuit imprimé de la revendication 1, cette carte à circuit imprimé étant une carte à circuit imprimé multicouche, et une portion du canal étant formée par l'enlèvement de portions d'une ou de plusieurs couches de la carte à circuit imprimé.

3. La carte à circuit imprimé de la revendication 1, le canal transportant un fluide de refroidissement.

4. La carte à circuit imprimé de la revendication 3, le fluide de refroidissement étant un gaz.

5. La carte à circuit imprimé de la revendication 3, le fluide de refroidissement étant un liquide.

6. La carte à circuit imprimé de la revendication 1, le dispositif comprenant une puce du transistor attachée à une collerette de montage, cette collerette de montage étant attachée à la surface de montage et comprenant la surface formant la portion respective du canal.

7. La carte à circuit imprimé de la revendication 1, le dispositif comprenant une puce de transistor attachée à la surface de montage, cette puce de transistor comprenant la surface formant la portion respective du canal.

8. La carte à circuit imprimé de la revendication 1, comprenant une pluralité de surfaces de montage de dispositifs pour y attacher des dispositifs producteurs de chaleur, le canal ayant une portion à proximité de chaque surface de montage.

**FIG. 1**
(Prior Art)

**FIG. 2A**
(Prior Art)

**FIG. 2B**

**FIG. 3**

**FIG. 4**

200

202
204
206
208

layer 1

344

346  344

322

346

layer N

312

**FIG. 5**

420

200  202  204
206
208

200  202
204
206
208

422

424  **430**  412  410  426

**112**

**FIG. 6**

**FIG. 7**